# EUROPÄISCHE PATENTSCHRIFT

(11) **EP 0 364 614 B1**
(45) Veröffentlichungstag und Bekanntmachung des Hinweises auf die Patenterteilung: **22.12.1993**
(21) Anmeldenummer: 88117264.7
(22) Anmeldetag: 17.10.1988
(51) Int. Cl.: G06F 15/70, H01L 21/00, G01B 11/00

(54) **Verfahren zur Erkennung der räumlichen Lage und Orientierung vorher bekannter Körper**
Method of recognising the spatial position and orientation of already known objects
Méthode de reconnaissance de la position et de l'orientation spatiale d'objets déjà connus

(43) Veröffentlichungstag der Anmeldung: 25.04.1990
(73) Patentinhaber: SIEMENS AKTIENGESELLSCHAFT, 80333 München (DE)
(72) Erfinder: Doemens, Günter, Dr., D-8150 Holzkirchen (DE); Mengel, Peter, Dr., D-8031 Eichenau (DE); Brendes, Martin, D-3300 Braunschweig (DE)

(56) Entgegenhaltungen:
- EP-A- 0 107 820
- EP-A- 0 141 706
- WO-A-87/03719
- US-A- 4 435 837
- US-A- 4 593 406
- US-A- 4 766 556
- IEEE TRANSACTIONS ON PATTERN ANALYSIS AND MACHINE INTELLIGENCE, Band PAMI-6, Nr. 4, Juli 1984, Seiten 430-441, IEEE, New York, US; B. CERNUSCHI-FRIAS et al.: "3-D space location and orientation parameter estimation of Lambertian spheres and cylinders from a single 2-D image by fitting lines and ellipses to thresholded data"

## Beschreibung

Im industriellen Bereich erfordert die überwiegende Mehrzahl der Erkennungsaufgaben dreidimensionale Bildauswerteverfahren, um reale Objekte bezüglich Lage, Orientierung und Beschaffenheit zu charakterisieren. Hierbei werden optische Sensoren eingesetzt, die eine direkte und vollständige Erfassung eines Werkstückes ermöglichen. Diese Sensoren erfassen beispielsweise die Oberflächenkoordinaten eines Werkstückes rasterartig in Form von Höhenabstandswerten. Dies heißt bezogen auf das allgemeine karthesische Koordinatensystem X,Y,Z daß die Koordinate Z, die definitionsgemäß die Höhe angibt, für jeden Punkt innerhalb des Rasters durch den Sensor ermittelt wird. Aus diesem Grund werden derartige Sensoren als 3D-Sensoren bezeichnet. In der Regel werden die Sensoren in Kombination mit einem Laser-Scanner betrieben, wobei ein bestimmter Abtastbereich, eine bestimmte Aufnahmegeschwindigkeit und eine bestimmte Anzahl von Oberflächenkoordinaten vorgegeben sind.

Die Vorteile von Verfahren, die auf dreidimensional aufgenommene Abstandsdaten zurückgreifen, gegenüber der Grauwertbildverarbeitung als zwei- oder dreidimensionale Informationsverarbeitung, sind unbestritten. Die Weiterentwicklung von den Verfahren, die auf dreidimensional aufgenommenen Abstandsdaten basieren ist zum Teil mit einer wesentlichen Erhöhung des Rechenaufwandes verbunden. Um trotzdem die Zuverlässigkeit der Mustererkennung, insbesondere die industriellen Anforderungen, wie Erkennung der Lage und Orientierung eines bereits bekannten Körpers, zu erhöhen, wird zum einen nach zuverlässigen Entscheidungskriterien und zum anderen nach Möglichkeiten der Datenreduzierung gesucht.

Für die gattungsgemäßen Verfahren ist in der Regel eine Wissensbasis in Form von einem bekannten Körper, der in einer Referenzlage liegt und von dem ein mittels 3D-Sensor aufgenommenes Abstandsbild existiert, notwendig. Durch Vergleich von Informationen aus der Wissensbasis mit aktuell von einem Meßobjekt aufgenommenen Informationen lassen sich Lage und Orientierung eines bekannten Körpers, in diesem Fall den Meßobjekt bezüglich der Referenzlage ermitteln. Dies kann durch die Auswertung von lokalen oder globalen Merkmalen geschehen. Werden lokale Merkmale herangezogen, so wird nur eine Eigenschaft eines Teils des Körpers beschrieben. Bei der Verwendung von globalen Merkmalen gehen alle bekannten Informationen über das Werkstück mit ein. Ein Verfahren, das globale Merkmale bei der Mustererkennung ausnutzt, ist beispielsweise in der EP-A-0 335 377 beschrieben.

In der Druckschrift von - P. Levi, R. Horner, "Bestimmung dreidimensionaler Symmetrie-Eigenschaften auf der Basis von Trägheitsmomenten", 5. DAGM-Symposium, Karlsruhe 1983, p. 337-342 - wird beschrieben, wie Teilansichten eines Objektes zu einer 3D-Darstellung dieses Objektes benützt werden können. Unter Verwendung von Abstandsdaten werden hier Symmetrieeigenschaften gängiger Volumenprimitive, wie z.B. Kugel, Kegel, Pyramide usw. untersucht, wobei Trägheitsmomente und Hauptträgheitsachsen berechnet werden. Hier ist es jedoch notwendig, das betrachtete Objekt zu drehen. Es können prinzipiell Objekte mit verschiedenen Trägheitsmomenten aufgrund vorher erstellter Wissensbasen differenziert und erkannt werden. Der Nachteil für die industrielle Anordnung liegt zum einen darin, daß in der Regel die gesamte vorhandene Zahl der Oberflächenpunkte eines Meßobjektes ausgewertet werden muß und zum anderen in der Begrenzung auf die Erkennung eines Volumenprimitives. Eine Lage oder Orientierungsbestimmung eines beliebig im Raum orientierten Meßobjektes in Bezug auf einer Referenzlage ist hier nicht möglich.

Der Erfindung liegt die Aufgabe zugrunde, ein Verfahren zur Erkennung der räumlichen Lage und Orientierung vorher bekannter Körper zur Verfügung zu stellen, mit dem eine sichere, genaue und störunanfällige Mustererkennung möglich ist und eine wesentliche Datenreduktion der Informationsmenge des aufgenommenen dreidimensionalen Bildes eines Meßobjektes erzielt werden kann.

Die Lösung dieser Aufgabe wird durch die Merkmale des Anspruches 1 wiedergegeben.

Der Erfindung liegt die Erkenntnis zugrunde, daß durch die Berechnung der Trägheitsmomente der Schnittlinie zwischen der Körperoberfläche eines Meßobjektes, das ein an sich bekannter Körper ist, und einem virtuellen Volumenprimitiv, sowie einer daran anschließenden Hauptachsentransformation ein äußerst zuverlässiges und zugleich einfaches Kriterium für die Erkennung der Lage und Orientierung des bekannten Körpers bezüglich einer Referenzlage gegeben ist. Bedingung hierfür ist, daß das Symmetriezentrum des virtuellen Volumenprimitives in einen vorbestimmten Punkt des bekannten Körpers belegt wird. Die Identifizierung dieser Punkte geschieht jeweils, indem die Hauptträgheitsmomente der Schnittlinien zwischen bekanntem Körper, hier das Meßobjekt, und dem virtuellen Volumenprimitiv ermittelt werden und mit der Wissensbasis, die gleichermaßen für eine Vielzahl von Punkten auf dem bekannten Körper in der Referenzlage die Hauptträgheitsmomente beinhaltet, verglichen werden. Ist für die bei der Messung berechneten Werte ein Eintrag in der Wissensbasis vorhanden, so ist der vorbestimmte Punkt, um den herum die Schnittbildung durchgeführt wurde, identifiziert. Dieser vorbestimmte Punkt steht damit in Zusammenhang mit der für diesen Fall erhaltenen Schnittlinie. Die Orientierung des Körpers im Raum ist damit auf die Orientierungsbestimmung einer Linie im Raum zurückgeführt worden. Die Orientierung bezüglich des allgemeinen karthesischen Koordinatensystemes ist bereits durch die Hauptachsentransformation und die Ermittlung der Hauptträgheitsmomente geschehen, womit die Orientierung des gesamten Meßobjektes feststeht. Die Lage des identifizierten Punktes bezüglich des Koordinatenursprunges kann direkt berechnet werden. Somit ist neben dem Rotationsanteil der translaterische Teil ermittelt. Beides zusammen gibt die Lage- und Orientierungsabweichung von der Referenzlage an.

In einer besonders vorteilhaften Ausgestaltung der Erfindung wird als virtuelles Volumenprimitiv eine Kugel verwendet. Für diesen Fall ist jeder Punkt der Schnittlinie vom Symmetriezentrum der Kugel und damit auch vom vorbestimmten Punkt des Meßobjektes gleich weit entfernt. Man erhält somit eine räumliche Linie, deren Form aufgrund der Rotationssymmetrie der Kugel von der Orientierung des Körpers unabhängig ist. Durch diese Rotationsinvarianz, bezogen auf den vorbestimmten Punkt, ist bei der Identifizierung des vorbestimmten Punktes, sowie der Orientierung des Körpers im Raum eine weitere wesentliche Vereinfachung des Verfahrens gegeben. Die Eindeutigkeit der Identifizierung ist bei dieser Ausgestaltung der Erfindung höher als beispielsweise bei der Benutzung eines Würfels als Volumenprimitiv.

Prinzipiell läßt sich bei der Auswahl des vorbestimmten Punktes des bekannten Körpers jeder Punkt innerhalb und auf der Oberfläche verwenden. Da die Grundlage des Verfahrens jedoch dreidimensional aufgenommene Abstandsdaten, d.h. Daten der Oberfläche eines Körpers sind, ist naheliegend, nicht einen im Inneren liegenden Punkt, sondern einen Oberflächenpunkt des Meßobjektes zu wählen. Punkte im inneren des Meßobjektes, wie z.B. der Volumenschwerpunkt, müßten separat berechnet werden.

Während des Verfahrens wird eine zur Berechnung der Trägheitsmomente der Schnittlinie nötige Diskretisierung dieser Linie in Form von auf der Linie verteilten Massenpunkten vorgenommen. Die Verteilung dieser Stützpunkte kann unregelmäßig in einer bestimmten Reihenfolge geschehen. Sie sollte jedoch für den Fall der Referenzlage in gleicher Weise dargestellt sein, wie für den Fall der Schnittbildung am Meßobjekt. In einer vorteilhaften Ausgestaltung der Erfindung ist vorgesehen, daß die Verteilung der Stützstellen über die Schnittlinie jeweils gleichmäßig geschieht.

Im folgenden wird anhand von schematischen Figuren ein Ausführungsbeispiel beschrieben:
Die Figur 1 zeigt einen bekannten Körper 1 mit Schnittlinien 5 und vorbestimmten Punkten 3.
Die Figur 2 zeigt den Schnitt zwischen einem bekannten Körper 1 und einem virtuellen Volumenprimitiv, einer Kugel.
Die Figur 3 zeigt eine Ausschnittsvergrößerung aus der Figur 2.
Die Figur 4 zeigt eine Schnittlinie 5 mit gleichmäßig verteilten Stützpunkten 4 unter Bezug auf das allgemeine karthesische Koordinatensystem X, Y, Z und das körperfesten Koordinatensystem X′,Y′,Z′.

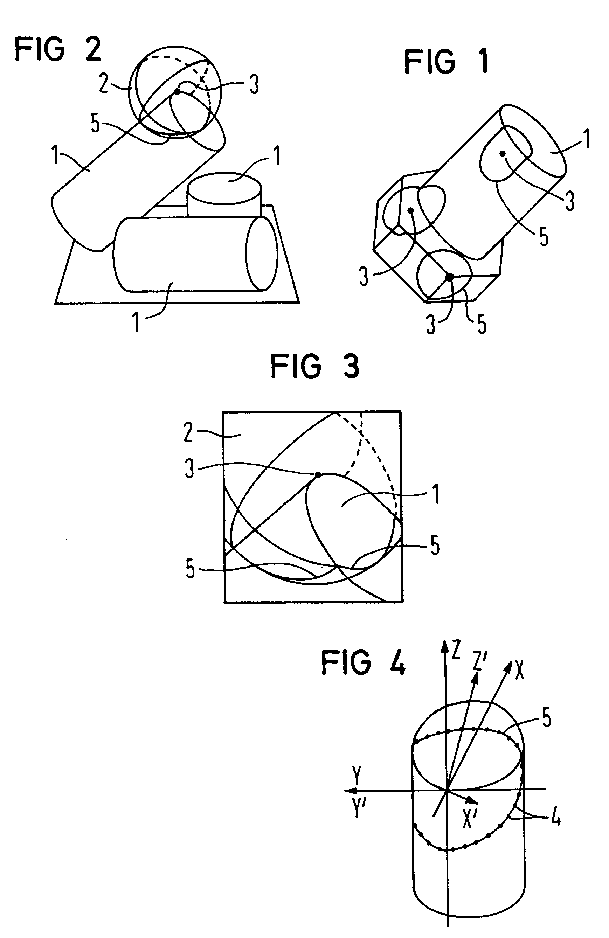

In der Figur 1 ist als bekannter Körper eine Schraube beispielhaft dargestellt. Es sind in diesem Fall drei vorbestimmte Punkte 3 eingetragen, in die das Symmetriezentrum des Volumenprimitives 2, in diesem Fall der Mittelpunkt einer Kugel, hineingelegt wurde. Die sich ergebenden Schnittlinien 5 sind andeutungsweise eingetragen. Ganz allgemein ist zu sagen, daß der bekannte Körper 1 bezüglich des allgemeinen karthesischen Koordinatensystemes X, Y, Z eine beliebig im Raum liegende Orientierung aufweist.

In der Figur 2 sind entsprechend einem möglichen industriellen Einsatzfall drei bekannte Körper 1 dargestellt. Der vorbestimmte Punkt 3 ist in diesem Fall als der höchste Punkt des Zylinders angedeutet. Der Schnitt mit dem virtuellen Volumenprimitiv 2, in diesem Fall einer Kugel, führt zu den Schnittlinien 5.

In der Figur 3 ist die nähere Umgebung des vorbestimmten Punktes 3, wie in der Figur 2 dargestellt, vergrößert gezeichnet. Unter der Voraussetzung, daß der vorbestimmte Punkt 3 zugleich Symmetriezentrum, also Mittelpunkt der Kugel ist, läßt sich hier deutlich machen, daß die Schnittlinie 5, die aus mehreren Abschnitten besteht, rotationsinvariant bei Drehungen irgendeiner Art um den vorbestimmten Punkt 3 ist.

In der Figur 4 ist das allgemeine karthesische Koordinatensystem X, Y, Z neben dem körperfesten Koordinatensystem X′, Y′, Z′ angedeutet. Die Hauptachsentransformation bestand in diesem Fall lediglich in einer Drehung um die Y-Achse. Die für einen bestimmten Anwendungsfall angedeutete Schnittlinie 5, die durch die gleichmäßige Verteilung von Stützpunkten 4 quantisiert wurde, ist über die Ermittlung der Summe aller Trägheitsmomente der Stützpunkte 4 im allgemeinen karthesischen Koordinatensystem X, Y, Z charakteristisch für die eine in diesem Fall durchgeführte Schnittbildung mit dem vorbestimmten Punkt 3 als Bezugspunkt, der gleichzeitig Symmetriezentrum des hier verwendeten Volumenprimitivs 2 ist. Zur Bestimmung des translatorischen Teiles, also der Lageabweichung bezüglich des Koordinatenursprunges oder eines Referenzpunktes kann der Volumenschwerpunkt des Körpers oder auch der Mittelpunkt der Schnittlinie verwendet werden. Die Lage der Punkte innerhalb des Körpers ist bekannt.

Als Volumenprimitiv 2 wird ein bezüglich der Symmetrie hochentwickeltes Gebilde angesehen, also beispielsweise eine Kugel, ein Würfel oder ein Zylinder. Durch die Schnittbildung eines an sich bekannten Körpers mit einer Kugel zum einen in einer Referenzlage und zum anderen in einer beliebig im Raum orientierten und verschobenen Lage, wird auf einfache Weise eine Rotationsinvariante Teilmenge aus dem aufgenommenen dreidimensionalen Abstandsbild extrahiert. Dies bedeutet, daß nicht nur einzelne lokale Merkmale in die Auswertung einfließen, sondern daß globale Kriterien, die eine Vielzahl von Informationen aus dem vorhandenen dreidimensionalen Abstandsbild beinhalten, zur Auswertung herangezogen werden. Durch mehrfache Anwendung dieser Vorgehensweise kann eine sichere und präzise Identifizierung erreicht werden. Die Unabhängigkeit von den optischen Eigenschaften der Werkstückoberflächen ist mit dem beschriebenen Verfahren gewährleistet. Eine Optimierung der Erfassungsgeschwindigkeit ist insofern verwirklicht worden, als der Rechenaufwand für die Erstellung des Modellwissens in der Wissensbasis vergrößert wurde, gleichzeitig jedoch die nötigen Rechenvorgänge während der Erfassung des Meßobjektes durch die Verwendung von einfachen Erkennungskriterien verringert wurde. Dabei ist anzumerken, daß die Wissensbasis trotzdem im Verhältnis zu Verfahren aus dem Stand der Technik relativ klein ist. Eine Besonderheit des Verfahrens liegt darin, daß keine Segmentierung der aufgenommenen Bilddaten vorgenommen werden muß, sondern die Informationsmenge durch die Schnittbildung mit einer virtuellen Kugel drastisch reduziert wird. Das Verfahren ist sehr robust gegen Störungen, beispielsweise das nicht zu verhindernde Rauschen, und ist zudem teileunabhängig. Somit können Körper verschiedenster Form damit erfaßt und ausgewertet werden. Ein ganz besonderer Vorteil des Verfahrens liegt darin, daß Fehler auf jeder Stufe der Verfahrenshierarchie zulässig sind. Die Ausnutzung von rotationsinvarianten Teilmengen der Körperoberfläche, die hierdurch ermöglichte Identifizierung bestimmter Punkte auf einem Meßobjekt, der Vergleich mit einer Wissensbasis und eine Mehrfachanwendung des Verfahrens bedingen teilweise einen Mittelungseffekt. Zudem werden auf einer Schnittlinie zur Berechnung der Trägheitsmomente bis zu ca. 70 Punkte gleichmäßig verteilt. Damit sind die nicht zu vermeidenden lokalen Fehlmessungen als Fehlerquelle ausgeschaltet, da ein einzelner Punkt nicht zu einer kompletten Auswertung herangezogen wird. Vielmehr werden globale Auswertekriterien verwendet, die auf einer Vielzahl von Meßdaten basieren.

Zur Durchführung des Verfahrens werden beispielsweise mittels des Triangulationsprinzipes über 3D-Sensoren und Laser-Scanner Höhenwerte eines Meßobjektes mit einer Datenrate von ca. 200 kHz erfaßt. Der Meßbereich des Scanners liegt in diesem Fall bei 100 x 100 x 100 mm. Die Auflösung in x- und y-Richtung beträgt ca. 8 Bit. Damit wurde ein Feld von 256 x 256 Höhenwerten bearbeitet.

Für die Bildung der Wissensbasis anhand einer Referenzlage des bekannten Körpers, die off-line geschieht, sind keinerlei Einschränkungen zu beachten. Während der on-line-Messung am Meßobjekt werden durch das Verfahren geringe Rechenzeiten erreicht.

Die Wissensbasis kann durch ein "teach in"-Verfahren, also durch Aufnahme eines realen Körpers erfolgen oder von einem CAD-Bild (computer added design) übernommen werden.

## Patentansprüche

1. Verfahren zur maschinellen Ermittlung von räumlichen Lage- und Orientierungswerten vorher bekannter Körper (1) anhand von dreidimensionalen Bilddaten, die in Form von über dreidimensional aufnehmende Sensoren ermittelten Höhenrasterbildern, die aus einer Vielzahl von gemessenen Oberflächenpunkten bestehen, vorliegen, und in einer Rechenanlage gespeichert werden, bei dem
- die Schnittlinien (5) zwischen der Oberfläche des bekannten Körpers (1) und der Oberfläche eines ebenfalls gespeicherten virtuellen Volumenprimitives (2) errechnet werden wobei
ein vorbestimmter Punkt (3) des bekannten Körpers (1) mit dem Symmetriezentrum des virtuellen Volumenprimitives (2) zusammenfällt,
- eine vorbestimmte Anzahl von Stützpunkten (4) auf die Schnittlinien (5) verteilt wird,
- ein Trägheitstensor durch die Ermittlung der Summe aller Trägheitsmomente der Stützpunkte (4) bezogen auf das allgemeine karthesische Koordinatensystem (x, y, z) errechnet wird und die Hauptträgheitsmomente und das zugehörige körperfeste Koordinatensystem (x', y', z') des bekannten Körpers (1) aus dem Trägheitstensor ermittelt werden,
- durch Vergleich von nach denselben bisherigen Verfahrensschritten an einem bekannten Körper (1) in einer Referenzlage für eine ausgewählte Anzahl von Oberflächenpunkten ermittelten Hauptträgheitsmomenten der Schnittlinie (5) mit den am bekannten Körper (1) als Meßobjekt ermittelten Hauptträgheitsmomenten der Schnittlinie (5) der vorbestimmte Punkt (3) errechnet wird und
- mittels des auf einen bestimmten Punkt des bekannten Körpers (1) bezogenen körperfesten Koordinatensystemes (x', y', z') die Lage- und Orientierungswerte des Meßobjektes bezüglich der Referenzlage errechnet werden.

2. Verfahren nach Anspruch 1,
**dadurch gekennzeichnet,**
daß als virtuelles Volumenprimitiv (2) eine Kugel verwendet wird.

3. Verfahren nach einem der vorhergehenden Ansprüche,
**dadurch gekennzeichnet,**
daß der vorbestimmte Punkt (3) ein ausgewählter Oberflächenpunkt des bekannten Körpers (1) ist.

4. Verfahren nach einem der vorhergehenden Ansprüche,
**dadurch gekennzeichnet,**
daß die vorbestimmte Anzahl von Stützpunkten (4) gleichmäßig auf den Schnittlinien (5) verteilt wird.

## Claims

1. Method for the automated determination of spatial position and orientation values of already known objects (1) with the aid of three-dimensional image data, which are available in the form of elevation raster images determined by means of three-dimensionally recording sensors, which images comprise a multiplicity of measured surface points, and are stored in a computer system, in which method
- the lines of intersection (5) between the surface of the known object (1) and the surface of a likewise stored virtual volume pattern (2) are computed,
a predetermined point (3) of the known object (1) coinciding with the centre of symmetry of the virtual volume pattern (2),
- a predetermined number of base points (4) are distributed on the lines of intersection (5),
- an inertia tensor is computed by the determination of the sum of all moments of inertia of the base points (4) related to the general cartesian coordinate system (x, y, z), and the principal moments of inertia and the associated object coordinate system (x', y', z') of the known object (1) are determined from the inertia tensor,
- by comparison of principal moments of inertia of the line of intersection (5) which are determined in accordance with the same former method steps on a known object (1) in a reference position for a selected number of surface points with the principal moments of inertia of the line of intersection (5) which are determined on the known object (1) as measurement object, the predetermined point (3) is computed and
- by means of the object coordinate system (x', y', z') related to a specified point of the known object (1), the position and orientation values of the measurement object with respect to the reference position are computed.

2. Method according to Claim 1, characterised in that a sphere is used as virtual volume pattern (2).

3. Method according to one of the preceding claims, characterised in that the predetermined point (3) is a selected surface point of the known object (1).

4. Method according to one of the preceding claims, characterised in that the predetermined number of base points (4) are uniformly distributed on the lines of intersection (5).

## Revendications

1. Procédé de détermination automatisé de valeurs tridimensionnelles de position et d'orientation d'objets déjà connus (1), au moyen de données d'image tridimensionnelles, qui sont présentes sous la forme d'images de trame en hauteur, qui sont fournies par l'intermédiaire de capteurs réalisant une détection en trois dimensions, qui sont constituées d'une multiplicité de points mesurés de la surface et qui sont mémorisées dans une installation de calcul, et selon lequel
- les lignes de coupe (5) entre la surface de l'objet connu (1) et la surface d'une forme primitive virtuelle de volume (2) également mémorisée sont calculées,
un point prédéterminé (3) de l'objet connu (4) coïncide avec le centre de symétrie de la forme primitive virtuelle de volume (2),
- un nombre préscrit de points de reprise (4) sont répartis sur les lignes de coupe (5),
- un tenseur d'inertie est calculé en faisant la somme de tous les moments d'inertie des points de reprise (4) au système général de coordonnées cartésiennes (x,y,z), et les moments d'inertie principaux et le système de coordonnées (x',y',z'), lié à l'objet connu (1), sont déterminés à partir du tenseur d'inertie,
- le point prédéterminé (3) est calculé en comparant les moments d'inertie principaux de la ligne de coupe (5), qui sont déterminés par les mêmes phases opératoires que précédemment sur un objet connu (1) dans une position de référence pour un nombre sélectionné de points de la surface, aux moments d'inertie principaux, déterminés sur l'objet connu (1) de la ligne de coupe (5), qui sert d'objet de mesure, et
- les valeurs de position et d'orientation de l'objet de mesure par rapport à la position de référence sont calculées au moyen du système de coordonnées (x',y',z'), lié à l'objet rapporté à un point déterminé de l'objet connu (1).

2. Procédé suivant la revendication 1, caractérisé par le fait qu'on utilise une sphère comme forme primitive virtuelle de volume (2).

3. Procédé suivant l'une des revendications précédentes, caractérisé par le fait que le point prédéterminé (3) est un point choisi de la surface de l'objet connu (1).

4. Procédé suivant l'une des revendications précédentes, caractérisé par le fait que les points de reprise (4), en un nombre prescrit, sont répartis uniformément sur les lignes de coupe (5).
